# EUROPÄISCHE PATENTSCHRIFT

(11) **EP 2 467 446 B1**
(45) Veröffentlichungstag und Bekanntmachung des Hinweises auf die Patenterteilung: **10.07.2013**
(21) Anmeldenummer: 10743107.4
(22) Anmeldetag: 11.08.2010
(51) Int. Cl.: C09K 11/59, C04B 35/581, C04B 35/584, C09K 11/80

(54) **KONVERSIONS-LED MIT HOHER FARBWIEDERGABE**
CONVERSION LED WITH HIGH COLOR RENDITION INDEX
DEL À CONVERSION PRÉSENTANT UN BON RENDU DES COULEURS

(30) Priorität: 17.08.2009 DE 102009037730
(43) Veröffentlichungstag der Anmeldung: 27.06.2012
(73) Patentinhaber: OSRAM GmbH, 80807 München (DE); Osram Opto Semiconductors Gmbh, 93055 Regensburg (DE)
(72) Erfinder: BAUMANN, Frank, 93055 Regensburg (DE); BOENISCH, Norbert, 81541 München (DE); FIEDLER, Tim, 81369 München (DE); JERMANN, Frank, 86343 Königsbrunn (DE); LANGE, Stefan, 86157 Augsburg (DE); WINDISCH, Reiner, 93186 Pettendorf (DE)
(86) Internationale Anmeldenummer: PCT/EP2010/061694
(87) Internationale Veröffentlichungsnummer: WO 2011/020756

(56) Entgegenhaltungen:
- EP-A1- 1 845 146
- EP-A2- 1 568 753
- US-A1- 2006 226 759
- US-A1- 2006 255 712

## Beschreibung

### Technisches Gebiet

Die Erfindung geht aus von einer Konversions-LED gemäß dem Oberbegriff des Anspruchs 1. Derartige Konversions-LEDs sind insbesondere für Allgemeinbeleuchtung geeignet.

### Stand der Technik

Aus der EP 1 696 016 ist eine Konversions-LED bekannt, die als roten Leuchtstoff ein Calsin verwendet. Eine weiße LED wird damit realisiert unter Verwendung einer blauen LED und einem gelben oder grünen Leuchtstoff ausgewählt als α -Sialon, Y2A15012:Ce oder (Y, Gd) 2 (Al, Ga) 5012 : Ce.

Aus der EP-A 1 669 429 ist eine Konversions-LED bekannt, die zur Erzielung einer weißen LED einen blauen Chip zusammen mit speziellem Leuchtstoff des Typs (Sr,Ba)2Si5N8:Eu verwendet, wobei als zusätzlicher Leuchtstoff zur Verbesserung der Farbwiedergabe auch Lu-AG:Ce sowie ähnliche Leuchtstoffe, die mit Ce und Pr kodotiert sind, verwendet werden.

### Darstellung der Erfindung

Die Aufgabe der vorliegenden Erfindung ist es, eine Konversions-LED bereitzustellen, die mit hoher Farbwiedergabe ausgestattet ist, wobei die Konversions-LED insbesondere eine hohe nutzbare Lebensdauer erreicht.

Diese Aufgabe wird gelöst durch die kennzeichnenden Merkmale des Anspruchs 1.

Besonders vorteilhafte Ausgestaltungen finden sich in den abhängigen Ansprüchen.

Erfindungsgemäß wird jetzt eine Konversions-LED hoher Effizienz bereitgestellt. Nicht alle Leuchtstoffe sind in bei hohen Strömen, hier insbesondere mindestens 250 mA, bevorzugt mindestens 300 mA, besonders bevorzugt mindestens 350 mA, betriebenen LEDs, sog. Hochleistungs-LED, stabil. Insbesondere gilt diese Problematik für nitridische oder oxinitridische Leuchtstoffe wie das Nitridosilikat M2Si5N8:Eu. Viele derartige Leuchtstoffe, insbesondere Nitride des Typs M2Si5N8:D mit D als Aktivator erleiden beim Betrieb in einer LED deutliche Konversionsverluste. In kurzer Zeit (typisch 1000 Std.) verlieren derartige LEDs bis zu 50% Konversionseffizienz. Dies führt zu einer ausgeprägten Instabilität des Farborts.

Weiße LEDs gewinnen in der Allgemeinbeleuchtung immer mehr an Bedeutung. Insbesondere steigt die Nachfrage nach warmweißen LEDs mit niedrigen Farbtemperaturen, bevorzugt im Bereich 2900 bis 3500 K, insbesondere 2900 bis 3100 K, und guter Farbwiedergabe, insbesondere Ra ist mindestens 93, bevorzugt mindestens 96, und gleichzeitig hoher Effizienz. Vor dem Hintergrund des kommenden Verbots der wenig energieeffizienten Allgebrauchsglühlampe gewinnen alternative Lichtquellen mit möglichst guter Farbwiedergabe (CRI) immer mehr an Bedeutung. Viele Verbraucher legen Wert auf Leuchtmittel mit glühlampenähnlichem Lichtspektrum.

Gängige kommerziell erhältliche warmweiße LEDs bestehen in der Regel aus einer Kombination einer blauen LED mit gelben und roten Leuchtstoffen. Der Farbwiedergabeindex liegt typischerweise meist um 80. Deutlich bessere Farbwiedergabeindizes werden in der Regel durch die Zugabe weiterer Leuchtstoffe erreicht, was auf die Verarbeitung, Farbortstabilität und Effizienzen allerdings einen negativen Einfluss hat. Zur Kompensation der Blau-Grün-Lücke im Spektrum werden zudem meist sehr langwellige blaue LEDs eingesetzt (ca. 460nm). Seitens der Chiptechnologie ist es aus Effizienzgründen jedoch vorteilhaft, LEDs kürzerer Chipwellenlängen einzusetzen, die deutlich effizienter sind. Gewünscht sind Wellenlängen (Peak) von 430 bis 455 nm, insbesondere 435 bis 445 nm.

Die Leuchtstoffe müssen eine Reihe von Anforderungen erfüllen: Eine sehr hohe Stabilität gegenüber chemischen Einflüssen, beispielsweise Sauerstoff, Feuchtigkeit, Wechselwirkungen mit Vergussmaterialien, sowie gegenüber Strahlung. Um einen stabilen Farbort bei steigender Systemtemperatur zu gewährleisten, sind außerdem Leuchtstoffe erforderlich, die ein sehr geringes Temperaturlöschverhalten aufweisen.

Bisherige warmweiße LEDs mit sehr hohem CRI werden in der Regel erreicht durch die Kombination aus einer relativ langwelligen LED mit einem blau-grünen, einem grün-gelben und einem roten Leuchtstoff. Sowohl die Verwendung langwelliger LEDs als auch der Einsatz von drei Leuchtstoffen sind aus Applikationssicht und unter Effizienzgesichtspunkten ungünstig.

Die neue Lösung besteht aus der Kombination aus einem neuartigen grünen Granatleuchtstoff und einem schmalbandigen roten Nitridoalumosilikat-Leuchtstoff. Der neue grüne Granatleuchtstoff zeigt gegenüber gebräuchlichen gelben (YAG) bzw. grüngelben (YAGaG) Granaten eine stark grünverschobene Emission auf, gleichzeitig ist das Anregungsoptimum stark kurzwellig verschoben.

Die spektralen Eigenschaften der oben beschriebenen Leuchtstoffkombination erlauben die Realisierung warmweißer LEDs bis hin zu Lösungen für 2900 bis 3100 K mit extrem hohem CRI von 96 bis 98 bei gleichzeitig sehr guter Rotwiedergabe (R9=90 bis 99) in Verbindung mit blauen LED-Chips mit einer Peakwellenlänge von 440 bis 445 nm. Selbst bei Verwendung sehr kurzwelliger Chips (Peakwellenlänge 435 nm) werden noch sehr gute 95 CRI-Punkte erreicht. Die Beschränkung auf nur zwei konvertierende Leuchtstoffe vereinfacht die Verarbeitung in der LED stark und wirkt sich positiv auf die Farbortstabilität aus. Die beiden Leuchtstoffe der neuartigen Lösung zeigen eine sehr hohe Stabilität in LED-Alterungstests. Weiterhin zeichnen sich beide Leuchtstoffe durch ein sehr niedriges Temperaturlöschverhalten aus.

Der entscheidende Fortschritt besteht jetzt darin, dass eine gleichzeitige Verbesserung mehrerer aus Applikationssicht zentraler Eigenschaften erreicht wurde, nämlich in Bezug auf Alterungsstabilität, Effizienz, verwendbarer Chipwellenlängenbereich und Temperaturstabilität der Leuchtstoffe. Der Unterschied dieser neuen Lösung gegenüber vorbekannten Warmweiß-Lösungen ist:
- Sehr stark grünverschobener, "intelligent" mit der LED-Wellenlänge schiebender Granatleuchtstoff. Dies bringt Vorteile in: CRI, Augenbewertung, Temperaturstabilität;
- kurze Chipwellenlänge. Dies bringt einen großen Vorteil im Hinblick auf hohe Effizienz;
- langwelliger, stabiler, aber gleichzeitig schmalbandiger, genau auf den Grünleuchtstoff abgestimmter Rotleuchtstoff. Dies bringt Vorteile in: LED-Lebensdauer (Effizienz, Farbortstabilität), relativ hohe Augenbewertung bei extrem guter Rotwiedergabe. Die volle Halbwertsbreite des schmalbandigen rot emittierenden Leuchtstoffs ist dabei bevorzugt kleiner als 90 nm FWHM erwünscht. Die volle Halbwertsbreite des schmalbandigen grün emittierenden Leuchtstoffs ist dabei bevorzugt kleiner als 115 nm FWHM erwünscht.

Wesentliche Merkmale der Erfindung in Form einer numerierten Aufzählung sind:
1. Konversions-LED mit einem Chip, der primäre Strahlung emittiert, sowie einer dem Chip vorgelagerten Leuchtstoff enthaltenden Schicht, die mindestens einen Teil der primären Strahlung des Chips in sekundäre Strahlung konvertiert, wobei ein erster gelb-grün emittierender Leuchtstoff des Typs Granat A3B5012:Ce und ein zweiter orange-rot emittierender Leuchtstoff des Typs Calsin MAlSiN3:Eu verwendet wird, dadurch gekennzeichnet, dass die Peak-Wellenlänge der primären Strahlung im Bereich 435 bis 455 nm liegt, wobei der erste Leuchtstoff ein Granat mit im wesentlichen dem Kation A = Lu oder Lu in Kombination mit Y ist, und wobei B gleichzeitig Anteile von Al und Ga aufweist, während der zweite Leuchtstoff vom grundsätzlichen Typ MAl-SiN3:Eu ist, das Ca als M mit einem Anteil von mindestens 80%, insbesondere mindestens 90%, bevorzugt mindestens 95%, enthält, mit M ist Ca allein oder überwiegend Ca und Rest von M kann Sr, Ba, Mg, Li oder Cu sein, jeweils allein oder in Kombination, und wobei ein Teil des Al bis 20%, bevorzugt höchstens 5%, durch B, O, F, Cl, allein oder in Kombination ersetzt sein kann..
2. Konversions-LED nach Anspruch 1, dadurch gekennzeichnet, dass der erste Leuchtstoff 10 bis 40 Mol.-% Ga, insbesondere 20 bis 30%, bei der Komponente B enthält, Rest ist Al.
3. Konversions-LED nach Anspruch 1, dadurch gekennzeichnet, dass der erste Leuchtstoff 1,5 % bis 2,9 Mol.-% Ce, insbesondere 1,8 bis 2,6 Mol.-% Ce, als Dotierung, die der Komponente A zugerechnet ist, enthält, Rest ist A.
4. Konversions-LED nach Anspruch 1, dadurch gekennzeichnet, dass der zweite Leuchtstoff alleine Ca als Komponente M enthält.
5. Konversions-LED nach Anspruch 1, dadurch gekennzeichnet, dass der zweite Leuchtstoff 0,2 bis 1,3 Mol.-% Eu, insbesondere 0,3 bis 0,9 %, als Dotierung, die der Komponente M zugerechnet ist, enthält.
6. Konversions-LED nach Anspruch 1, dadurch gekennzeichnet, dass der zweite Leuchtstoff CaAlSiN3:Eu mit 0,3 bis 0,8 % Eu-Anteil von M ist.
7. Konversions-LED nach Anspruch 6, dadurch gekennzeichnet, dass der erste Leuchtstoff A3B5012 ist, mit A = 75 bis 100% Lu, Rest Y und einem Ce-Gehalt von 1,5 bis 2,5%, mit B = 10 bis 40 % Ga, Rest Al.
8. Konversions-LED nach Anspruch 7, dadurch gekennzeichnet, dass der erste Leuchtstoff A3B5012 ist, mit A = 80 bis 100% Lu, Rest Y und einem Ce-Gehalt von 1,5 bis 2,5%, mit B = 15 bis 25 % Ga, Rest Al.

### Kurze Beschreibung der Zeichnungen

Im Folgenden soll die Erfindung anhand mehrerer Ausführungsbeispiele näher erläutert werden. Die Figuren zeigen:
- Fig. 1: eine Konversions-LED;
- Fig. 2: einen Vergleich der Temperaturabhängigkeit verschiedener rot emittierender Leuchtstoffe;
- Fig. 3: einen Vergleich der Temperaturabhängigkeit verschiedener grün emittierender Leuchtstoffe;
- Fig. 4: einen Vergleich der Zeitabhängigkeit der Konverter-Verluste für verschiedene Leuchtstoffe;
- Fig. 5: einen Vergleich des CRI für verschiedene Leuchtstoffmischungen bei Wellenlängenverschiebung der Primäranregung;
- Fig.: 6 einen Vergleich des R9 für verschiedene Leuchtstoffmischungen bei Wellenlängenverschiebung der Primäranregung;
- Fig. 7: einen Vergleich der Gesamtemission einer Konversions-LED bei verschiedener Primäremission;
- Fig. 8-10: einen Vergleich der Emission von LuAGaG bzw. YAGaG bzw. Misch-Sion bei verschiedener Peaklage der Primäremission (Ex);
- Fig. 11: ein LED-Modul mit entfernt angebrachter Leuchtstoffmischung.
- Figur 12: einen Vergleich der Emission bei Calsinen, die O enthalten;
- Figur 13: einen Vergleich der Emission bei Calsinen, die Cl enthalten;
- Figur 14: einen Vergleich der Emission bei Calsinen, die F enthalten;
- Figur 15: einen Vergleich der Emission bei Calsinen, die Cu enthalten;
- Figur 16: einen Vergleich der Emission bei Calsinen, die verschiedenen Gehalt an Eu enthalten;
- Figur 17: einen Vergleich der Emission bei Lu-Granaten, die verschiedenen Gehalt an Y enthalten.

### Bevorzugte Ausführungsform der Erfindung

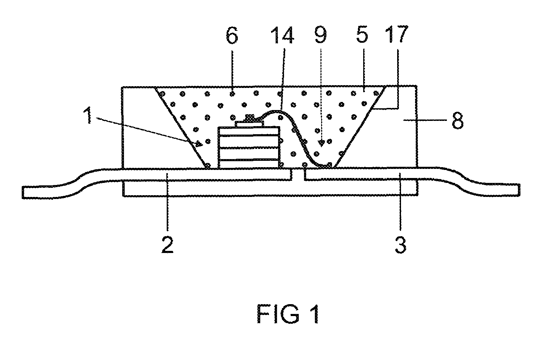

Figur 1 zeigt den Aufbau einer Konversions-LED für weißes Licht auf RGB-Basis wie an sich bekannt. Die Lichtquelle ist ein Halbleiterbauelement mit einem blau emittierende Chip 1 des Typs InGaN mit einer Peakemissionswellenlänge von 435 bis 455 nm Peakwellenlänge, beispielsweise 445 nm, das in ein lichtundurchlässiges Grundgehäuse 8 im Bereich einer Ausnehmung 9 eingebettet ist. Der Chip 1 ist über einen Bonddraht 14 mit einem ersten Anschluss 3 und direkt mit einem zweiten elektrischen Anschluss 2 verbunden. Die Ausnehmung 9 ist mit einer Vergussmasse 5 gefüllt, die als Hauptbestandteile ein Silikon (60- 90 Gew.-%) und Leuchtstoffpigmente 6 (weniger als 40 Gew.-%) enthält. Ein erster Leuchtstoff ist ein grün emittierender Granat-Leuchtstoff LuAGaG:Ce, sowie ein rot emittierendes Alumonitridosilikat CaAlSiN3:Eu. Die Ausnehmung hat eine Wand 17, die als Reflektor für die Primär- und Sekundärstrahlung vom Chip 1 bzw. den Pigmenten 6 dient.

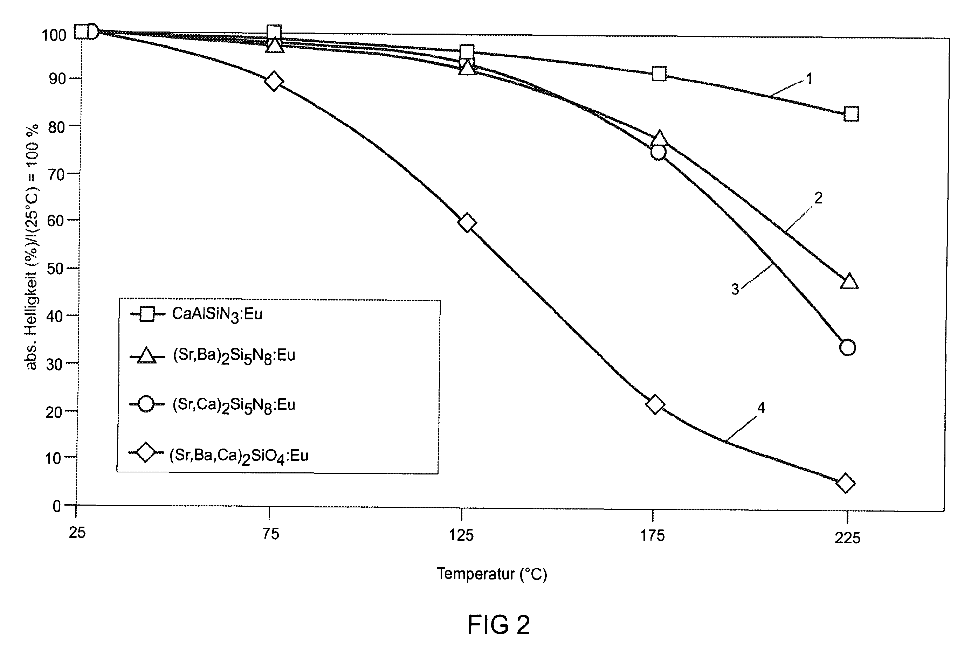

Figur 2 zeigt das Temperaturlöschungs-Verhalten verschiedener rot emittierender Leuchtstoffe, die sich im Prinzip gut mit dem Chip aus Figur 1 anregen lassen. Der neue tiefrote Leuchtstoff CaAlSiN3:Eu oder (Ca1-xEux)AlSiN3 zeichnet sich durch sehr geringe Temperaturlöschung aus. Dabei ist ein Anteil von 0,3% (x=0,003) bis 0,8% Eu (x=0,008) besonders gut geeignet. Allgemein ist bevorzugt ein Eu-Anteil an M=Ca von x = 0,002-0,012, besonders bevorzugt x = 0,003-0,009. Er zeichnet sich durch sehr geringe Temperaturlöschung aus, siehe Kurve 1. Die Grafik zeigt einen Vergleich mit anderen orange/roten Leuchtstoffen. Deutlich schlechter geeignet sind Nitridosilikate mit Ba oder Ca, siehe Kurve 2 und 3. Ungeeignet sind Orthosilikate (Kurve 4). Der Leuchtstoff CaAlSiN3:Eu (Farbkoordinaten CIE mit x/y = 0,657/0,341) lässt sich in der Regel auf vielfältige Weise für spezielle Anforderungen modifizieren, ohne dass sich die Emission entscheidend ändert. Dabei lässt sich Ca in kleinen Anteilen bis 20%, insbesondere bis 10%, durch Ba,Sr,Mg,Li oder Cu allein oder in Kombination ersetzen. Ähnliches gilt für den Al-Anteil. Er kann in kleinen Mengen, insbesondere bis 10%, durch B oder O allein oder in Kombination ersetzt sein.

Ein Beispiel eines modifizierten Leuchtstoffs (Ca0.892Mg0.1Eu0.008) (Al0.99B0.01) Si1N3 (CIE-x/y = 0,657/0340) vom grundsätzlichen Strukturtyp "CaAlSiN3:Eu" ist in Tabelle 3 angegeben. Weitere Modifikationen mit leicht geändertem Kationenverhältnis oder partieller Ca-Sr-Substitution ggf. zusammen mit einer partiellen O/N-Substitution - wie z. B. (Ca_{0.945}Sr_{0.045} Eu_{0.01})AlSi(N_{2.9}O_{0.1})- sind ebenfalls möglich.

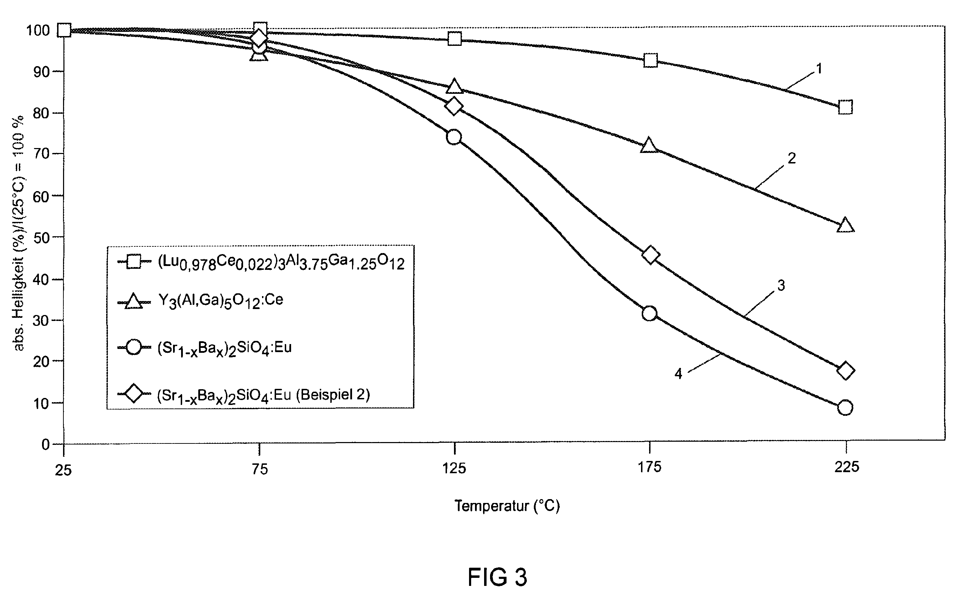

Figur 3 zeigt das Temperaturlöschungs-Verhalten verschiedener gelb-grün emittierender Leuchtstoff, die sich im Prinzip gut mit dem Chip aus Figur 1 anregen lassen. Der Leuchtstoff A3B5012:Ce in der Ausführungsform mit der bevorzugten Zusammensetzung LuAGaG, also Lu3 (Al, Ga) 5012:Ce mit ca. 25% Anteil Ga für Komponente B (bevorzugt sind 10-40% Ga-Anteil, besonders bevorzugt sind 15-30% Ga-Anteil) und ca. 2,2% Ce (bevorzugt sind 1.5-2.9% Ce, besonders bevorzugt 1.8-2.6% Ce, jeweils bezogen auf den Anteil A), zeichnet sich durch sehr geringe Temperaturlöschung aus. Ein bevorzugter Leuchtstoff ist (Lu0.978Ce0.022) 3Al3.75Ga1.25012, siehe Kurve 1. Die Grafik zeigt einen Vergleich mit anderen gelben und grünen Leuchtstoffen, die ein wesentlich schlechteres Temperaturlöschungs-Verhalten zeigen. Orthosilikate (Kurve 3,4) sind völlig ungeeignet, aber auch YAGaG, also Y3(Al,Ga)5012:Ce gemäß Kurve 2, ist deutlich schlechter.

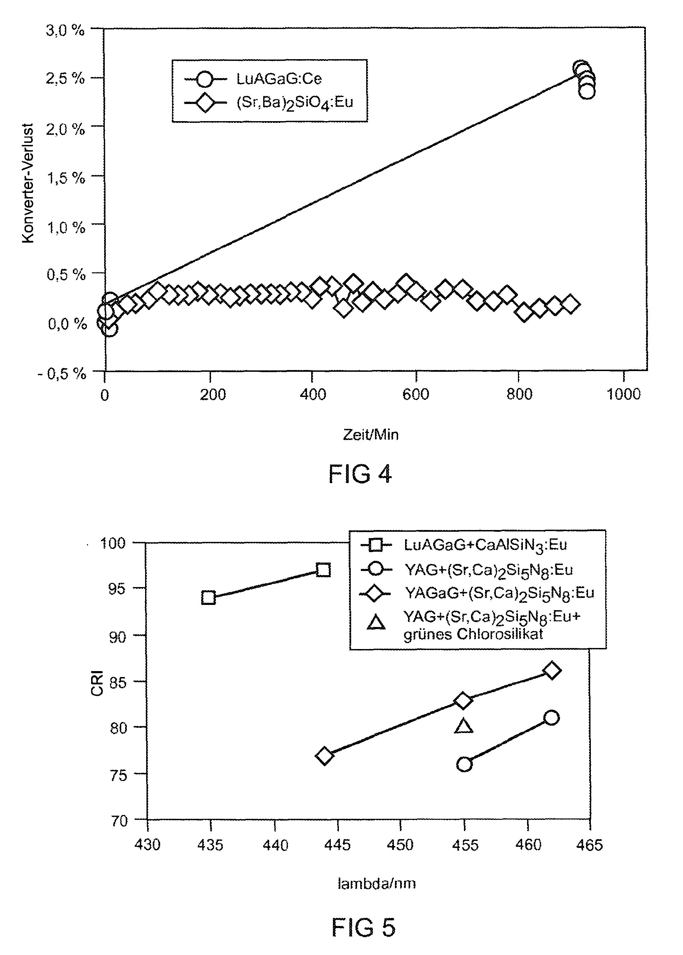

Figur 4 zeigt die Stabilität der gelb-grün-Komponente. In einem LED-Alterungstest wurde die Stabilität des Grünleuchtstoffs mit der bevorzugten Zusammensetzung LuAGaG mit ca. 25% Ga und ca. 2,2% Ce, (Lu0.978Ce0.022) 3Al3.75Ga1.25012) ermittelt und mit anderen bekannten gelb/grün emittierenden Leuchtstoffen verglichen. Dabei wurde eine blaue Hochleistungs-LED (λₚₑₐₖ=435 nm) mit einer Dispersion des jeweiligen Leuchtstoffs in Silikon vergossen und diese bei 350 mA für 1000 h betrieben. Die relativen Intensitäten des blauen LED-Peaks sowie des Leuchtstoffpeaks wurden zum Beginn und zum Ende gemessen und daraus der Verlust der Konversionseffizienz bestimmt. Dieser LuAGaG-Leuchtstoff ist im Rahmen der Messfehler perfekt stabil (viereckige Messpunkte), während ein Orthosilikat unter vergleichbaren Bedingungen deutliche Alterungserscheinungen zeigt (runde Messpunkte).

Die Farbwiedergabe der warmweißen LED mit der erfindungsgemäßen neuen Leuchtstoffmischung (LuAGaG plus tiefrotes CaAlSiN3) zeigt eine geringe Abhängigkeit von der eingesetzten anregenden blauen LED-Wellenlänge. Eine Verschiebung der Peak-Wellenlänge um 9 nm bewirkt in der Farbwiedergabe nur einen CRI-Verlust (Ra8) von 3 Punkten. Typische andere Mischungen verlieren bereits bei einem Unterschied von 7 nm Peak-Wellenlänge im Blauen 5 Punkte (siehe Tabelle 1). Um dort dann den CRI-Verlust auf 1 Punkt zu verringern, ist die Zugabe eines dritten Leuchtstoffs nötig, was die Effizienz und das Colour-Steering negativ beeinflusst. Insbesondere wird auch die Abhängigkeit der Farbwiedergabe von gesättigtem Rot sehr stark verringert, wie am Einzelwert für R9 deutlich wird.

Tab. 1 zeigt für die letzten beiden Muster, dass im Bereich 435 nm bis 445 nm Peakwellenlänge der anregenden LED bei einer Farbtemperatur von 3000 bis 3100 K herausragende Werte des CRI, nämlich Ra8 ist mindestens 94 und des Rot-Index R9, mindestens 90, möglich sind.

**Tab. 1**

| Peak-Wellenlänge der blauen LED / nm | Farbtemperatur /K | Leuchtstoff 1 (grün-gelb) | Leuchtstoff 2 (orange-rot) | Leuchtstoff 3 (blau-grün) | Verhältnis gelb:rot | Farbwiedergabeindex Ra8 | R9 |
|---|---|---|---|---|---|---|---|
| 462 | 3200 | YAG:3%Ce | (Sr,Ca) 2Si5N8: Eu (60% Sr) | - | 9:1 | 81 | 23 |
| 455 | 3250 | YAG:3%Ce | (Sr,Ca) 2Si5N8: Eu (60% Sr) | - | 10.3:1 | 76 | 8 |
| 455 | 3200 | YAG:3%Ce | (Sr,Ca) 2Si5N8: Eu (60% Sr) | grünes Chlorosilikat | 9:1 | 80 | 25 |
| 462 | 3250 | YAGaG:4%Ce (25%Ga) | (Sr,Ca) 2Si5N8: Eu (60% Sr) | - | 6.1:1 | 86 | 43 |
| 455 | 3250 | YAGaG:4%Ce (25%Ga) | (Sr,Ca) 2Si5N8: Eu (60% Sr) | - | 7:1 | 83 | 34 |
| 444 | 3200 | YAGaG:4%Ce (25%Ga) | (Sr,Ca) 2Si5N8: Eu (60% Sr) | - | 7:1 | 77 | 20 |
| 444 | 3050 | LuAGaG:2.2%Ce (25%Ga) | CaAlSiN3:Eu | - | 3.35:1 | 97 | 96 |
| 435 | 3025 | LuAGaG:2.2%Ce (25%Ga) | CaAlSiN3:Eu | - | 2:1 | 94 | 96 |

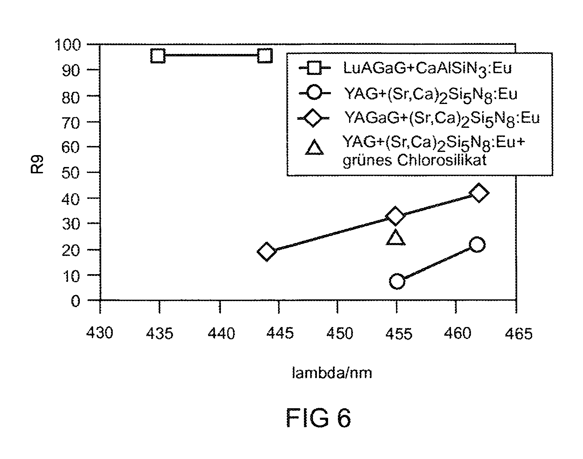

Figur 5 und 6 zeigen den Farbwiedergabeindex (CRI) Ra8 sowie den Rot-Index R9 für verschiedene Systeme. Die Farbwiedergabe der warmweißen LED mit der erfindungsgemäßen neuen Leuchtstoffmischung (LuAGaG+tiefrotes CaAlSiN3) zeigt nur eine geringe Abhängigkeit von der eingesetzten LED-Wellenlänge. Eine Verschiebung der Blau-Wellenlänge um 9 nm bewirkt nur einen CRI-Verlust von 3 Punkten. Typische andere Mischungen verlieren bereits bei einem Unterschied von 7 nm Blau-Wellenlänge 5 Punkte (siehe Tabelle 1). Um dort den CRI-Verlust auf 1 Punkt zu verringern, ist die Zugabe eines dritten Leuchtstoffs nötig, was die Effizienz und das Colour-Steering negativ beeinflusst.

Insbesondere wird auch die Abhängigkeit der Farbwiedergabe von gesättigtem Rot sehr stark verringert, wie am Einzelwert für R9 deutlich wird, siehe Figur 6.

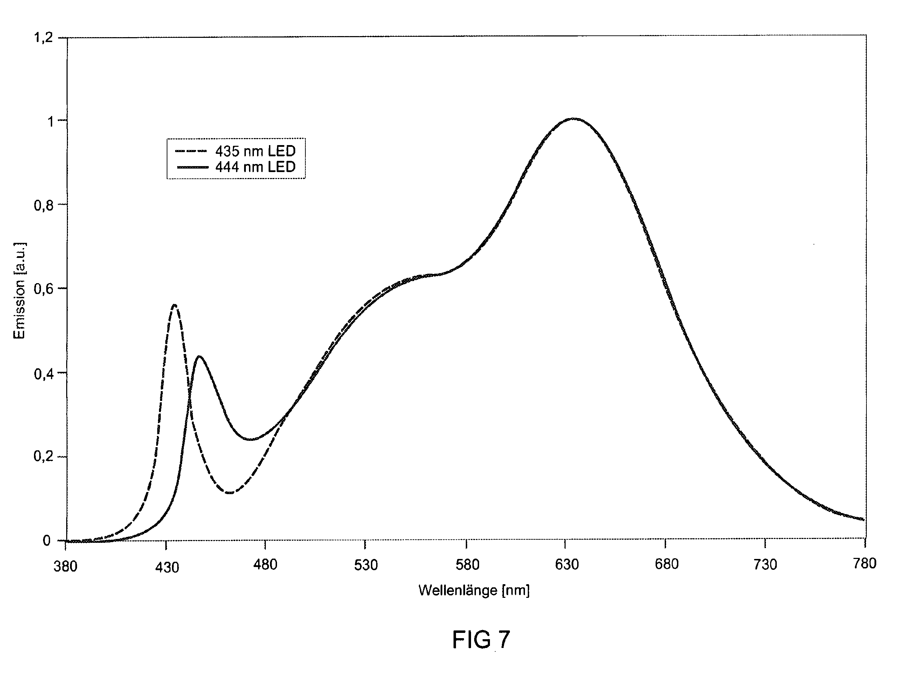

Figur 7 erläutert die Ursache für die geringe Abhängigkeit des Farbwiedergabeindex CRI von der Blau-Wellenlänge: Die Leuchtstoff-Emission verschiebt sich beim erfindungsgemäßen System überraschend mit zunehmend kurzwelliger Anregungswellenlänge deutlich zu kurzen Wellenlängen hin, siehe den Bereich bei etwa 530 nm. Dadurch ergibt sich eine gewisse Kompensation im Gesamtspektrum: Die beim Einsatz einer kürzerwellig emittierenden LED fehlenden Blau-Grün-Anteile werden durch die verstärkten Blau-Grün-Anteile der verschobenen Leuchtstoffemission nahezu ausgeglichen.

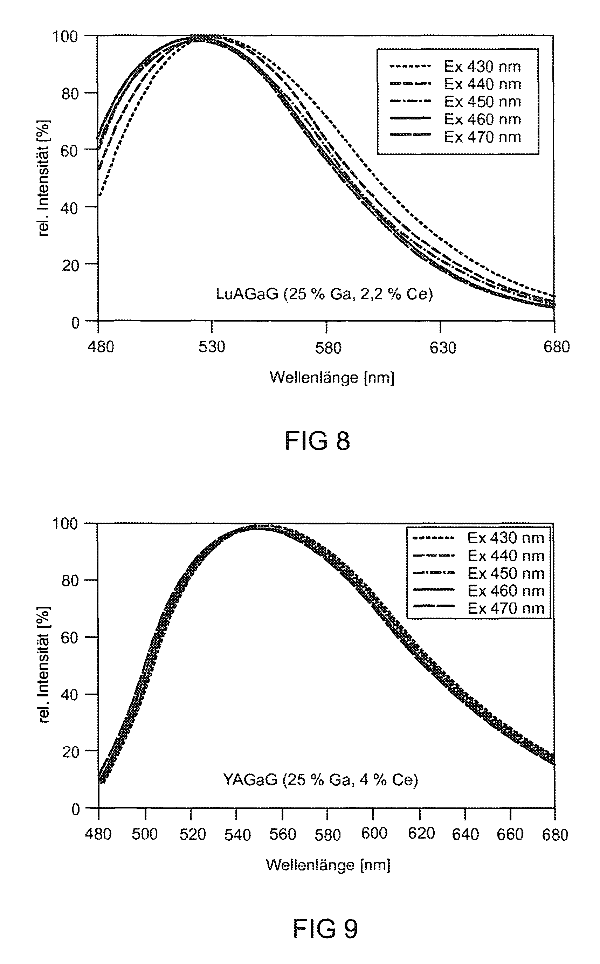

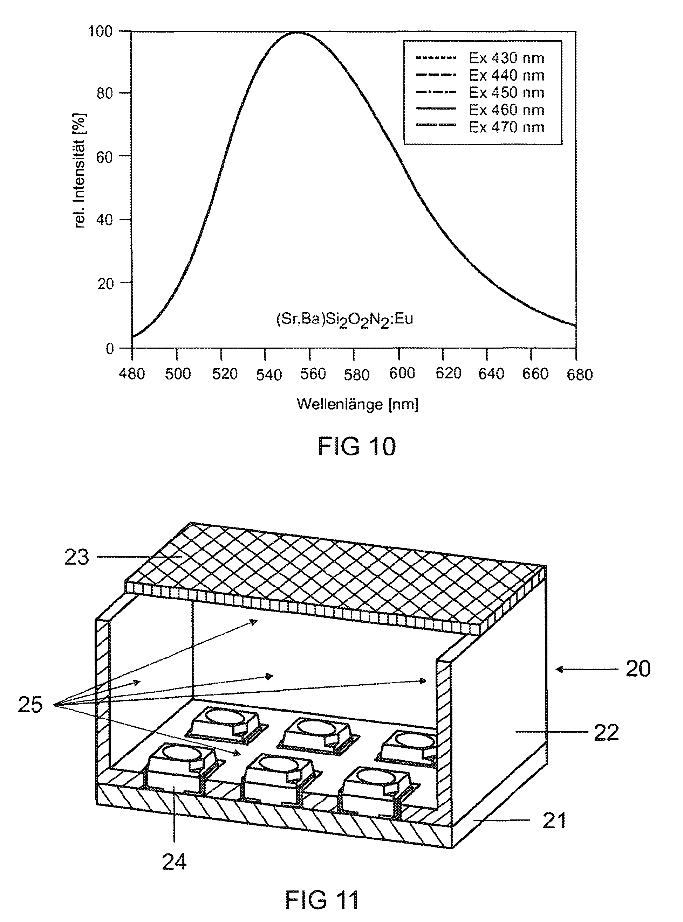

Figur 8 zeigt die relative Intensität bei einer Verschiebung des Leuchtstoffspektrums des Grün-gelb-Leuchtstoffs mit variabler Anregungswellenlänge zwischen 430 und 470 nm (Ex430 bis 470) im Vergleich zu YAGaG:Ce (Figur 9) und gelbem (Sr,Ba) Si2O2N2:Eu (Figur 10).

Überraschenderweise verhält sich der neue grüne LuAGaG-Granat deutlich anders als die Vergleichs-Leuchtstoffe. Er zeigt eine starke Grünverschiebung mit sinkender Anregungswellenlänge. Die Vergleichs-Leuchtstoffe bleiben etwa konstant. Gezeigt sind die Emissionsspektren der drei Leuchtstoffe im Vergleich im für LED-Anwendungen interessanten Bereich der Anregung durch eine LED mit Peak-Wellenlänge zwischen 430 und 470 nm. Die Kurven der Figur 10 liegen praktisch alle so dicht übereinander, dass nur eine Kurve erkennbar ist.

Der Einsatz eines Lutetium-Granats wirkt sich insgesamt deutlich positiv auf die Farbwiedergabe aus. Im Vergleich mit Yttrium-Granaten mit ähnlicher Leuchtstoff-Emissionswellenlänge ergeben sich bei LuAGaG deutlich höhere Farbwiedergabewerte Ra8 und R9, siehe Tabelle 2. Dadurch und durch die gute Anregbarkeit bei kurzen Wellenlängen können erstmals hocheffiziente, kurzwellige blaue LEDs für warmweiße Konversions-LED für eine Farbtemperatur von 2900 bis 3150 K eingesetzt werden.

**Tab. 2**

| Peak-Wellenlänge der blauen LED / nm | Farbtemperatur /K | Leuchtstoff 1 (grün-gelb) | Leuchtstoff 2 (orange-rot) | Verhältnis gelb:rot | Ra8 | R9 (tiefrot) |
|---|---|---|---|---|---|---|
| 444 | 3050 | YAGaG:40%Ga, 2%Ce | CaAlSiN3:Eu | 2.3:1 | 95 | 82 |
| 444 | 3000 | LuAGaG:2.2%Ce, 25%Ga | CaAlSiN3:Eu | 2.55:1 | 98 | 96 |
| 444 | 3050 | LuAGaG:2.2%Ce, 25%Ga | CaAlSiN3:Eu | 3.6:1 | 98 | 99 |

Mit nur zwei Leuchtstoffen wird eine sehr hohe Farbwiedergabe erreicht, trotz kurzwelliger blauer LED im Bereich 435 bis 455 nm. Dabei ist die spezielle Abstimmung der beiden gewählten Leuchtstoffe aufeinander wichtig. Beispielsweise erhöht der Einsatz eines noch längerwellig emittierenden Rotleuchtstoffs vom Typ Nitridosilikat nicht den CRI-Wert oder den Wert für die Rotwiedergabe R9, sondern liefert schlechtere Werte. Der Einsatz von Y-Granaten führt nicht zu derart hohen Werten, die mit Lu-Granat realisierbar sind. Details verschiedener Mischungen finden sich in Tab. 3. Gd ist als wesentliche Komponente völlig ungeeignet und sollte, ebenso wie Tb oder La, höchstens zur Feinabstimmung in kleinen Mengen bis 5 Mol.-% der Komponente A zugesetzt werden. Dagegen liefert ein Anteil Y bis etwa 30%, bevorzugt mit einem Anteil 10 bis 25%, eine gute Ergänzung zu Lu. Ursache ist der relativ ähnliche Ionenradius von Lu und Y. Höhere Werte von Y würden die Emission des Leuchtstoffs aber wieder in einen Bereich verschieben, der die gewünschte Performance des Gesamtsystems beeinträchtigen würde.

**Tabelle 3: Verschiedene Leuchtstottmischungen bei ca. 3000 K im Vergleich (bevorzugte Lösungen in Fettdruck); Peak steht für Peak-Wellenlänge der blauen LED (nm); R9 bezeichnet gesättigtes Rot.**

| Peak nm | Farbtemperatur / K | Leuchtstoff 1 (grün-gelb) | Leuchtstoff 2 rot) | Verhältnis gelb:rot | Ra8 | R9 |
|---|---|---|---|---|---|---|
| 444 | 3050 | YAGaG:40%Ga,2%Ce | Ca0,94Eu0,02Li0,045A13,8Si8,2N1 8 | 2.2:1 | 89 | 66 |
| 444 | 3000 | YAGaG:40%Ga,2%Ce | Sr1,14Ca0,74Eu0,12Si5N8 | 9.4:1 | 89 | 62 |
| 444 | 3000 | YAGaG:40%Ga,2%Ce | Ca0,992EU0,008AlSiN3 | 3:1 | 94 | 83 |
| 444 | 3050 | YAGaG:40%Ga,2%Ce | Sr0.76Ba0.96Ca0.16Eu0.12Si5N8 | 9:1 | 84 | 32 |
| 444 | 3050 | YAGaG:40%Ga,2%Ce | Ca0,992Eu0,008AlSiN3 | 2.3:1 | 95 | 82 |
| **444** | 3000 | LuAGaG:2.5%Ce,25%Ga | Ca0,992Eu0,008AlSiN3 | 2.55:1 | 98 | 96 |
| **444** | 3050 | LuAGaG:2.2%Ce,25%Ga | Ca0,992Eu0,008AlSiN3 | 3.6:1 | 98 | 99 |
| 435 | 3025 | LuAGaG:2.2%Ce,25%Ga | Ca0,992Eu0,008AlSiN3 | 2:1 | 94 | 96 |
| **444** | 3000 | LuAGaG:2.2%Ce,25%Ga | Ca0.892Mg0.1Eu0.008A10.99B0.01S ilN3 | 3:1 | 97 | 94 |

Grundsätzlich ist die Verwendung der Leuchtstoff-Mischung als Dispersion, als Dünnfilm etc. direkt auf der LED oder auch, wie an sich bekannt, auf einem separaten, der LED vorgeschalteten Träger möglich. Figur 11 zeigt ein derartiges Modul 20 mit diversen LEDs 24 auf einer Grundplatte 21. Darüber ist ein Gehäuse montiert mit Seitenwänden 22 und einer Deckplatte 12. die Leuchtstoff-Mischung ist hier als Schicht 25 sowohl auf den Seitenwänden als auch vor allem auf der Deckplatte 23, die transparent ist, angebracht.

Grundsätzlich ist es nicht ausgeschlossen, dass der erfindungsgemäße Granat außer dem überwiegenden Lu als wesentliche Komponente auch Anteile an Y als Kation A aufweist. Diese sollten im Bereich bis maximal 32% liegen. Andere Kationen wie Tb, La etc. sind als Zusatz nicht kategorisch ausgeschlossen, sie sollten aber wegen ihrer mangelnden Anpassung an das System (Lu,Y) nur in kleinen Mengen, bevorzugt maximal 5% von A, für etwaige spezielle Anpassungen der Eigenschaften des Leuchtstoffs verwendet werden.

Geeignete modifizierte Calsine sind in Tab. 4 gezeigt. Es handelt sich dabei um Systeme, die vom Grundsystem CaAlSiN3:Eu abstammen. Dabei können die Elemente O, F, Cl einen Anteil des N ersetzen. das Element Cu kann einen Anteil Ca ersetzen.

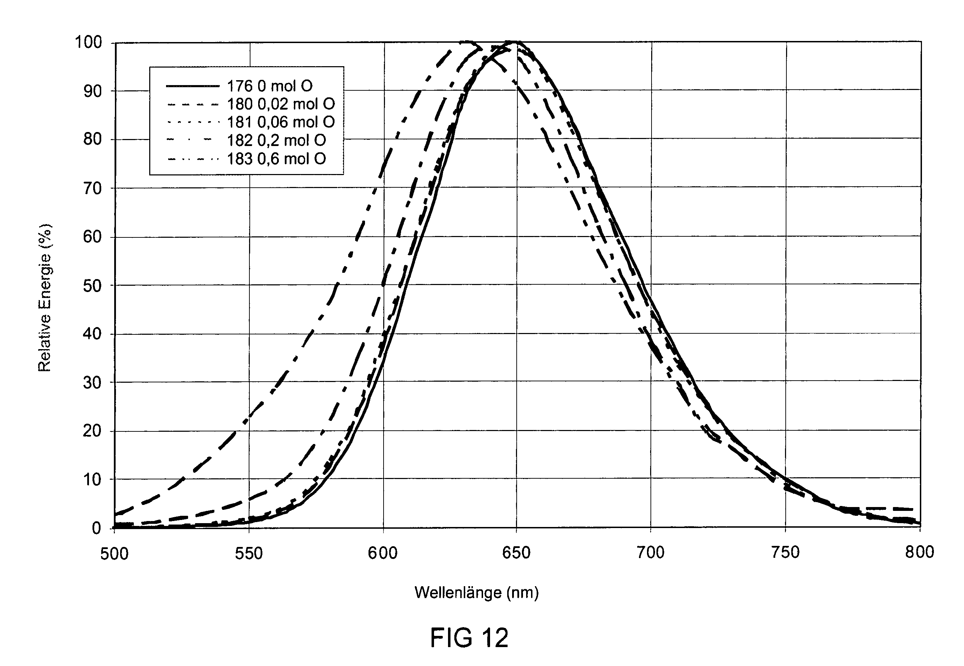

Figur 12 zeigt Emissionsspektren für verschiedene Calsine, bei denen N partiell durch kleine Mengen O ersetzt ist, siehe Tab. 4. Um die Halbwertsbreite nicht zu stark zu verbreitern, sollte der O-Anteil bevorzugt 0,2 Mol.-% nicht übersteigen.

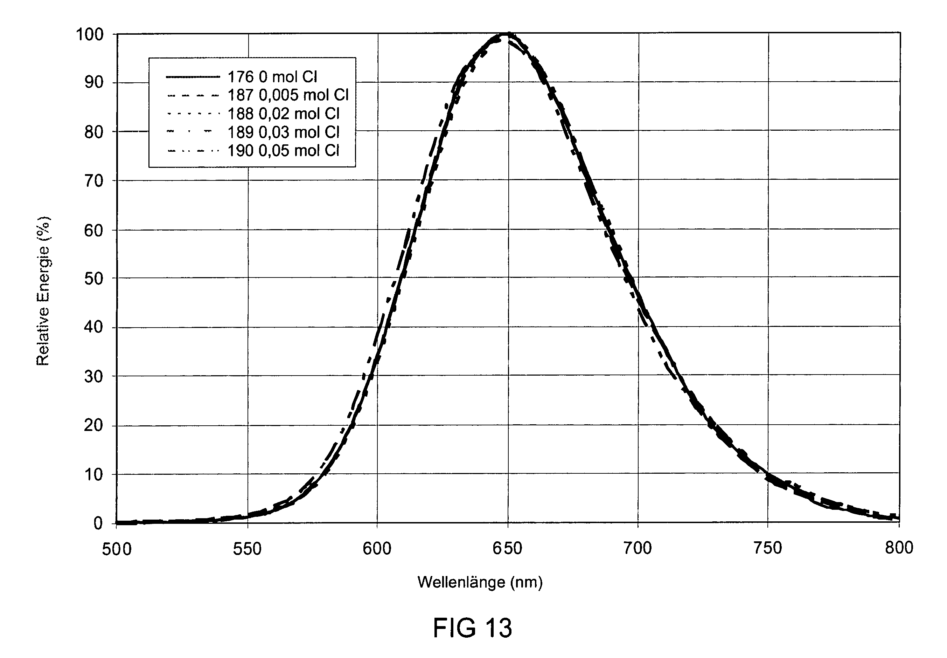

Figur 13 zeigt Emissionsspektren für verschiedene Calsine, bei denen N partiell durch kleine Mengen Cl ersetzt ist, siehe Tab. 4. Um die Halbwertsbreite nicht zu stark zu verbreitern, sollte der Cl-Anteil bevorzugt 0,05 Mol.-% nicht übersteigen.

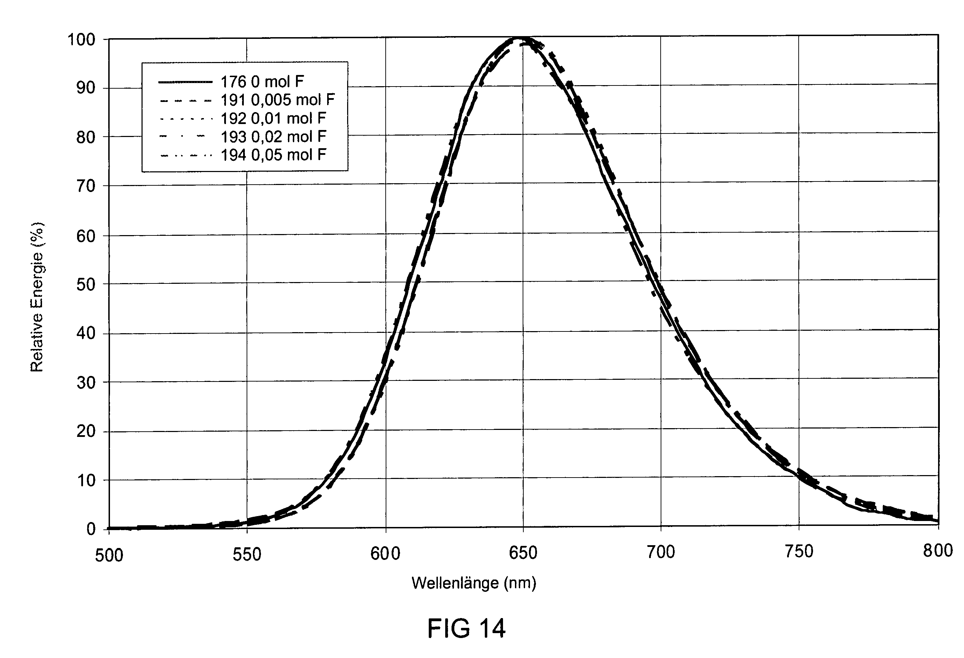

Figur 14 zeigt Emissionsspektren für verschiedene Calsine, bei denen N partiell durch kleine Mengen F ersetzt ist, siehe Tab. 4. Um die Halbwertsbreite nicht zu stark zu verbreitern, sollte der F-Anteil bevorzugt 0,05 Mol.-% nicht übersteigen.

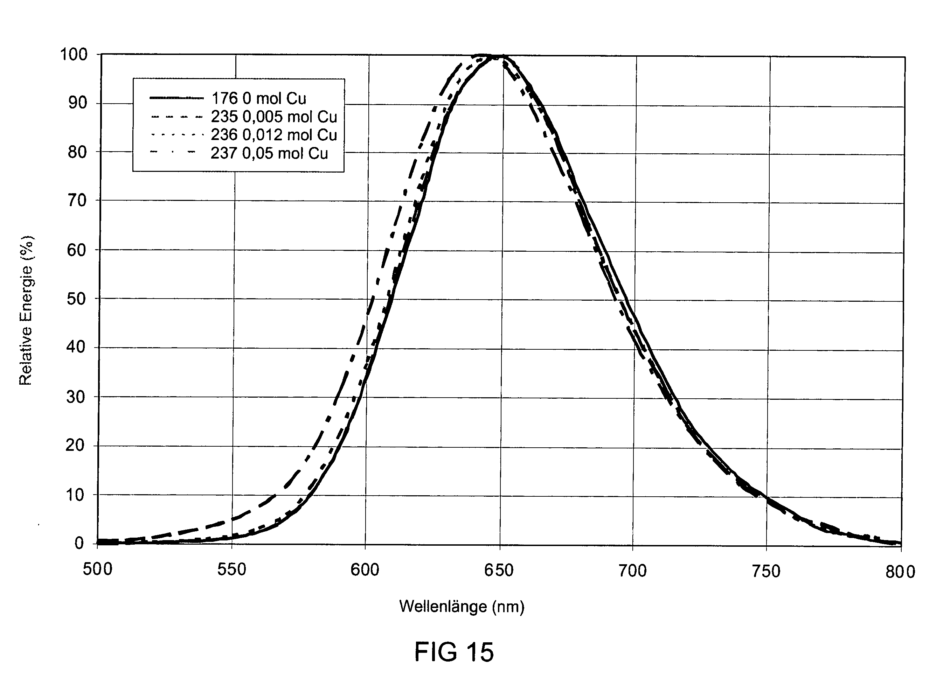

Figur 15 zeigt Emissionsspektren für verschiedene Calsine, bei denen Ca partiell durch kleine Mengen Cu ersetzt ist, siehe Tab. 4. Damit lässt sich eine Verschiebung zu kürzeren Wellenlängen hin erreichen. Um die Effizienzverluste aufgrund von Gitterverzerrungen nicht zu stark werden zu lassen, sollte der Cu-Anteil bevorzugt 0,05 Mol.-% nicht übersteigen. Die Herstellung gelingt hier auf folgende Weise:

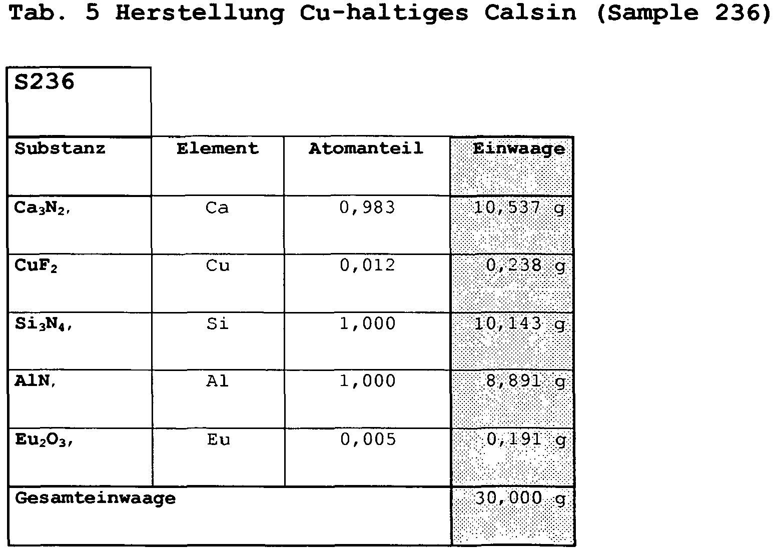

Alle Ausgangsmaterialien werden innerhalb der Glovebox eingewogen und in einer Kugelmühle 6 Stunden homogenisiert. Das Gemisch wird locker in einen dicht schließenden Tiegel aus Molybdän gefüllt und in einen Hochtemperatur-Rohrofen überführt.

Die Glühung wird unter fließender Stickstoff-Atmosphäre durchgeführt (2L/min). Mit einer Geschwindigkeit von 250 K/h wird die Probe auf 1600°C aufgeheizt, dort 4 Stunden gehalten und mit ebenfalls 250K/h auf Raumtemperatur abgekühlt.

Der resultierende Glühkuchen wird in einer Mörsermühle gemahlen und über einer 30 µm-Gaze gesiebt. Das Siebgut wird wieder in den Tiegel gefüllt und nochmals analog zur ersten Glühung getempert.

Der entstehende Glühkuchen wird in einer Mörsermühle gemahlen und über einer 30 µm-Gaze gesiebt. Das Siebgut ist der Leuchtstoff S 236.

Die Herstellung von Calsin als Sample S176 ist in Tab. 6 gezeigt.

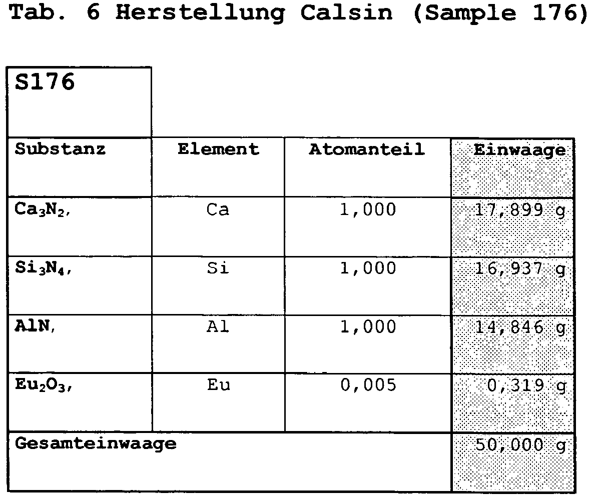

Alle Ausgangsmaterialien werden innerhalb der Glovebox eingewogen und in einer Kugelmühle 6 Stunden homogenisiert. Das Gemisch wird locker in einen dicht schließenden Tiegel aus Molybdän gefüllt und in einen Hochtemperatur-Rohrofen überführt.

Die Glühung wird unter fließender Stickstoff-Atmosphäre durchgeführt. Mit einer Geschwindigkeit von 250 K/h wird die Probe auf 1600°C aufgeheizt, dort 4 Stunden gehalten und mit ebenfalls 250K/h auf Raumtemperatur abgekühlt.

Der resultierende Glühkuchen wird in einer Mörsermühle gemahlen und über einer 30 µm-Gaze gesiebt. Das Siebgut wird wieder in den Tiegel gefüllt und nochmals analog zur ersten Glühung getempert.

Der entstehende Glühkuchen wird in einer Mörsermühle gemahlen und über einer 30 µm-Gaze gesiebt. Das Siebgut ist der Leuchtstoff S176.

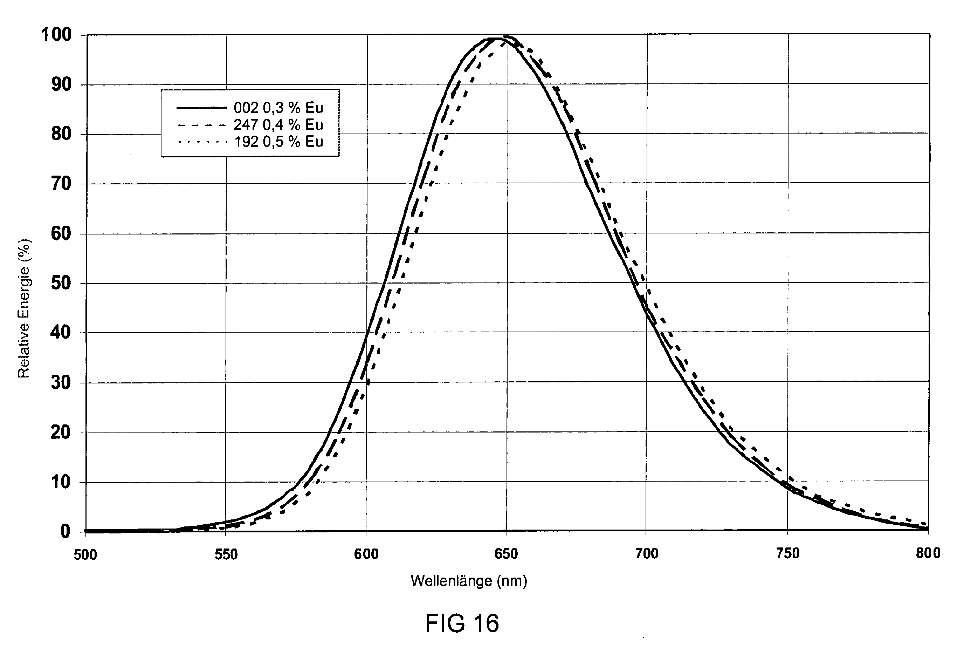

Figur. 16 zeigt Emissionsspektren für verschiedene Calsine, bei denen der Anteil des Aktivators Eu variiert wurde. Es zeigt sich, dass die Emission sich zu kürzeren Wellenlängen hin verschiebt, je kleiner die Konzentration des Aktivators gewählt ist. Sie liegt hier zwischen 0,3 und 0,5 Mol.-%.

Tab. 7 zeigt verschiedene Granate aus dem System A3B5012:Ce mit A ausgewählt aus (Lu,Y). Dabei zeigt sich, dass für A=Lu bis hin zu A= 70%Lu, Rest Y gute Werte erzielt werden können. Gleichzeitig muss für Komponenten B das Verhältnis zwischen Al und Ga sorgfältig gewählt werden. Der Anteil Ga sollte zwischen 10 und 40 Mol.-%, insbesondere 10 bis 25% liegen. Dabei sind in Tab. 7 verschiedene (Lu,Y)-Granate A3B5012:Ce gezeigt, wobei die Konzentration des Aktivators Ce jeweils 2% von A beträgt und A = Lu,Y (angegeben ist der Anteil des Lu, Rest ist Y) sowie B= Al, Ga (angegeben ist der Anteil Ga, Rest ist Al) gewählt ist.

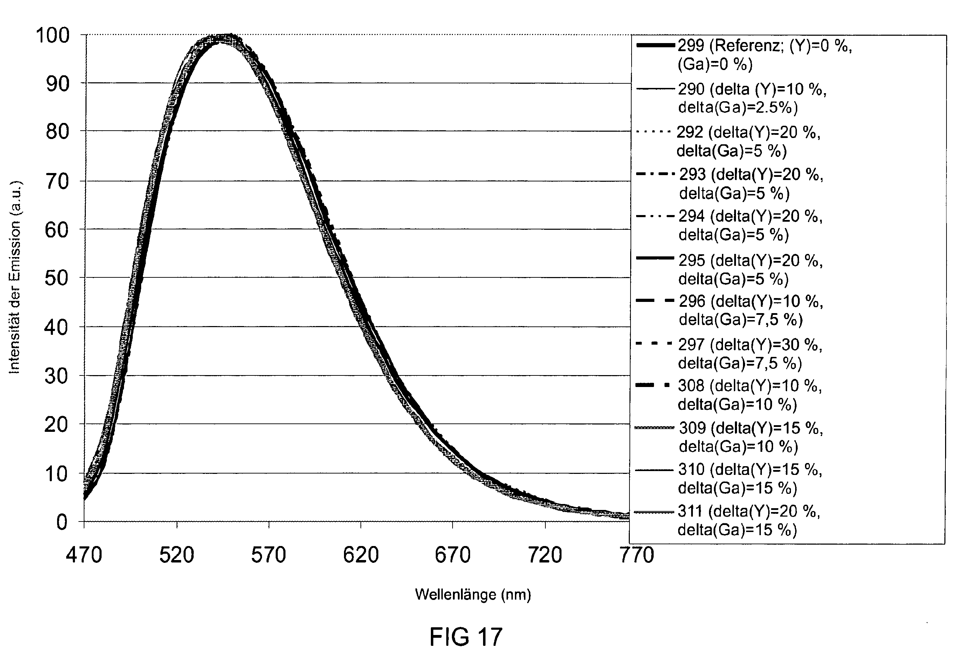

Figur 17 zeigt Emissionsspektren für verschiedene Granate, bei denen der Anteil des Y variiert wurde. Es zeigt sich, dass die Emission für kleine Anteil Y nahezu konstant bleibt.

Tab. 4 zeigt reine LuAGAG-Leuchtstoffe mit schrittweise erhöhtem Ga-Anteil. Diese Tabellenwerte, auch der anderen Tabellen, beziehen sich grundsätzlich immer auf eine Referenzanregung bei 460 nm.

**Tab. 8: Lu(Al,Ga)-Granate A3B5012:Ce (sog. LuAGAG)**

| Probennummer | Anteil Lu, Rest Y | Anteil Ga, Rest Al | x | y | lambda_dom / nm | FWHM / nm | rel. QE |
|---|---|---|---|---|---|---|---|
| **SL 315c/08** | **100%** | **5,0%** | **0,350** | **0,567** | **557,5** | **109,1** | **1,00** |
| **SL 005c/09** | **100%** | **15,0%** | **0,337** | **0,572** | **555,1** | **104,3** | **1,01** |
| **SL 003c/09** | **100%** | **20,0%** | **0,351** | **0,564** | **557,7** | **108,4** | **1,05** |
| **SL 167c/08** | **100%** | **25,0%** | **0,352** | **0,562** | **557,9** | **109,8** | **1,05** |

**Tab. 7: (Lu,Y)-Granate A3B5012:Ce**

| Probennummer | Anteil Lu, Rest Y | Anteil Ga, Rest Al | x | y | lambda_dom / nm | FWHM / nm | rel. QE |
|---|---|---|---|---|---|---|---|
| **SL 299c/08** | **100%** | **0,0%** | **0,393** | **0,557** | **564,2** | **112,5** | **1,00** |
| **SL 290c/08** | **88%** | **2,5%** | **0,396** | **0,556** | **564,6** | **113,2** | **1,02** |
| **SL 291c/08** | **68%** | **2,5%** | **0,414** | **0,550** | **567,1** | **115,4** | **1,01** |
| **SL 292c/08** | **78%** | **5,0%** | **0,400** | **0,555** | **565,2** | **113,7** | **1,01** |
| **SL 293c/08** | **78%** | **5,0%** | **0,400** | **0,556** | **565,1** | **114,3** | **1,01** |
| **SL 294c/08** | **78%** | **5,0%** | **0,401** | **0,555** | **565,3** | **114,8** | **1,02** |
| **SL 295c/08** | **78%** | **5,0%** | **0,401** | **0,555** | **565,3** | **113,8** | **1,02** |
| **SL 296c/08** | **88%** | **7,5%** | **0,388** | **0,559** | **563,5** | **112,8** | **1,02** |
| **SL 297c/08** | **68%** | **7,5%** | **0,402** | **0,555** | **565,4** | **114,4** | **1,03** |
| **SL 308c/08** | **88%** | **10,0%** | **0,383** | **0,560** | **562,8** | **112,1** | **1,03** |
| **SL 309c/08** | **83%** | **10,0%** | **0,387** | **0,559** | **563,3** | **112,5** | **1,03** |
| **SL 310c/08** | **83%** | **15,0%** | **0,381** | **0,560** | **562,5** | **113,0** | **1,03** |
| **SL 311c/08** | **78%** | **15,0%** | **0,385** | **0,559** | **563,1** | **112,3** | **1,02** |

| **Sample** | **Summenformel** | **ZusatzElement (x)** | **Mol (Zus-Elem.)** | **rel. Q.E.** | **x** | **y** | **λ dom** | **FWHM** | | | |
|---|---|---|---|---|---|---|---|---|---|---|---|
| 176 | CaAlSiN3:Eu+2 (0,5%) | nein | ---- | 100,0% | 0,664 | 0,332 | 610,7 | 87,3 | | | |
| 180 | CaAl1-xSi1+xN3-xOx:Eu+2 (0,5%) | O | 0,020 | 103,9% | 0,660 | 0,335 | 609,7 | 88,2 | | | |
| 181 | CaAl1-xSi1+xN3-xOx:Eu+2 (0,5%) | O | 0,060 | 103,3% | 0,658 | 0,338 | 608,8 | 88,4 | | | |
| 182 | CaAl1-xSi1+xN3-xOx:Eu+2 (0,5%) | O | 0,200 | 93,7% | 0,634 | 0,358 | 603,2 | 90,2 | | | |
| 183 | CaAl1-xSi1+xN3-xOx:Eu+2 (0,5%) | O | 0,600 | 77,7% | 0,583 | 0,406 | 592,8 | 104,4 | | | |
| 187 | CaAl1+2xSi1-2xN3-xClx:Eu+2 (0,5%) | Cl | 0,005 | 100,4% | 0,664 | 0,332 | 610,7 | 87,3 | | | |
| 188 | CaAl1+2xSi1-2xN3-xClx:Eu+2 (0,5%) | Cl | 0,020 | 100,5% | 0,666 | 0,330 | 611,3 | 86,7 | | | |
| 189 | CaAl1+2xSi1-2xN3-xClx:Eu+2 (0,5%) | Cl | 0,030 | 101,4% | 0,664 | 0,331 | 611,0 | 87,6 | | | |
| 190 | CaAl1+2xSi1-2xN3-xClx:Eu+2 (0,5%) | Cl | 0,050 | 101,2% | 0,659 | 0,336 | 609,4 | 88,5 | | | |
| 191 | CaAl1+2xSi1-2xN3-xFx:Eu+2 (0,5%) | F | 0,005 | 103,8% | 0,670 | 0,327 | 612,4 | 87,0 | | | |
| 192 | CaAl1+2xSi1-2xN3-xFx:Eu+2 (0,5%) | F | 0,010 | 101,4% | 0,670 | 0,326 | 612,7 | 86,9 | | | |
| 193 | CaAl1+2xSi1-2xN3-xFx:Eu+2 (0,5%) | F | 0,020 | 101,9% | 0,668 | 0,327 | 612,4 | 87,2 | | | |
| 194 | CaAl1+2xSi1-2xN3-xFx:Eu+2 (0,5%) | F | 0,050 | 99,5% | 0,662 | 0,333 | 610,3 | 87,0 | | | |

**Tab. 4: die Konzentration an Eu ist 0,5% bezogen auf M (hier Ca bzw Ca und Cu)**

| | | | | | | | | | | | |
|---|---|---|---|---|---|---|---|---|---|---|---|
| 235 | (Ca1-xCuxAl1+4xSi1-4xN3-2xF2x:Eu(0.5%) | Cu, F | 0,005 | 93,3% | 0,665 | 0,332 | 610,7 | 86,4 | | | |
| 236 | (Ca1-xCuxAl1+4xSi1-4xN3-2xF2x:Eu(0.5%) | Cu, F | 0,012 | 93,5% | 0,661 | 0,335 | 609,7 | 87,4 | | | |
| 237 | (Ca1-xCuxAl1+4xSi1-4xN3-2xF2x:Eu(0.5%) | Cu, F | 0,050 | 86,9% | 0, 640 | 0,354 | 604,2 | 91,5 | | | |

## Patentansprüche

1. Konversions-LED mit einem Chip, der primäre Strahlung emittiert, sowie einer dem Chip vorgelagerten Leuchtstoff enthaltenden Schicht, die mindestens einen Teil der primären Strahlung des Chips in sekundäre Strahlung konvertiert, wobei ein erster gelb-grün emittierender Leuchtstoff des Typs Granat A3B5012:Ce und ein zweiter orange-rot emittierender Leuchtstoff des Typs Calsin MAlSiN3:Eu verwendet wird, **dadurch gekennzeichnet, dass** die Peak-Wellenlänge der primären Strahlung im Bereich 435 bis 455 nm liegt, wobei der erste Leuchtstoff ein Granat mit dem Kation A = Lu oder Lu in Kombination mit Y ist, und wobei B gleichzeitig Anteile von Al und Ga aufweist, während der zweite Leuchtstoff MAl-SiN3:Eu ist, das Ca als M mit einem Anteil von mindestens 80%, insbesondere mindestens 90%, bevorzugt mindestens 95%, enthält, mit M ist Ca allein oder überwiegend Ca und Rest von M kann Sr, Ba, Mg, Li oder Cu sein, jeweils allein oder in Kombination, und wobei ein Teil des Al bis 20%, bevorzugt höchstens 5%, durch B, O, F, Cl, allein oder in Kombination ersetzt sein kann..

2. Konversions-LED nach Anspruch 1, **dadurch gekennzeichnet, dass** der erste Leuchtstoff 10 bis 40 Mol.-% Ga, insbesondere 20 bis 30%, bei der Komponente B enthält, Rest ist Al.

3. Konversions-LED nach Anspruch 1, **dadurch gekennzeichnet, dass** der erste Leuchtstoff 1,5 % bis 2,9 Mol.-% Ce, insbesondere 1,8 bis 2,6 Mol.-% Ce, als Dotierung, die der Komponente A zugerechnet ist, enthält, Rest ist A.

4. Konversions-LED nach Anspruch 1, **dadurch gekennzeichnet, dass** der zweite Leuchtstoff alleine Ca als Komponente M enthält.

5. Konversions-LED nach Anspruch 1, **dadurch gekennzeichnet, dass** der zweite Leuchtstoff 0,2 bis 1,3 Mol.-% Eu, insbesondere 0,3 bis 0,9 %, als Dotierung, die der Komponente M zugerechnet ist, enthält.

6. Konversions-LED nach Anspruch 1, **dadurch gekennzeichnet, dass** der zweite Leuchtstoff CaAlSiN3:Eu mit 0,3 bis 0,8 % Eu-Anteil von M ist.

7. Konversions-LED nach Anspruch 6, **dadurch gekennzeichnet, dass** der erste Leuchtstoff A3B5012 ist, mit A = 75 bis 100% Lu, Rest Y und einem Ce-Gehalt von 1,5 bis 2,5%, mit B = 10 bis 40 % Ga, Rest Al.

8. Konversions-LED nach Anspruch 7, **dadurch gekennzeichnet, dass** der erste Leuchtstoff A3B5012 ist, mit A = 80 bis 100% Lu, Rest Y und einem Ce-Gehalt von 1,5 bis 2,5%, mit B = 15 bis 25 % Ga, Rest Al.

## Claims

1. Conversion LED comprising a chip, which emits primary radiation, and comprising a phosphor-containing layer placed in front of the chip, said layer converting at least part of the primary radiation of the chip into secondary radiation, wherein a first, yellow-green-emitting phosphor of the type garnet A3B5012:Ce and a second, orange-red-emitting phosphor of the type Calsin MAlSiN3:Eu are used, **characterized in that** the peak wavelength of the primary radiation is in the range of 435 to 455 nm, wherein the first phosphor is a garnet comprising the cation A = Lu or Lu in combination with Y, and wherein B simultaneously comprises proportions of Al and Ga, while the second phosphor is MAlSiN3:Eu containing Ca as M with a proportion of at least 80%, in particular at least 90%, preferably at least 95%, where M is Ca alone or predominantly Ca and the remainder of M can be Sr, Ba, Mg, Li or Cu, in each case alone or in combination, and wherein part of the Al up to 20%, preferably at most 5%, can be replaced by B, O, F, Cl, alone or in combination.

2. Conversion LED according to Claim 1, **characterized in that** the first phosphor contains 10 to 40 mol% of Ga, in particular 20 to 30%, in the component B, the remainder being Al.

3. Conversion LED according to Claim 1, **characterized in that** the first phosphor contains 1.5% to 2.9 mol% of Ce, in particular 1.8 to 2.6 mol% of Ce, as doping ascribed to the component A, the remainder being A.

4. Conversion LED according to Claim 1, **characterized in that** the second phosphor contains Ca alone as component M.

5. Conversion LED according to Claim 1, **characterized in that** the second phosphor contains 0.2 to 1.3 mol% of Eu, in particular 0.3 to 0.9%, as doping ascribed to the component M.

6. Conversion LED according to Claim 1, **characterized in that** the second phosphor is CaAlSiN3:Eu with 0.3 to 0.8% Eu proportion of M.

7. Conversion LED according to Claim 6, **characterized in that** the first phosphor is A3B5012, where A = 75 to 100% Lu, remainder Y, and having a Ce content of 1.5 to 2.5%, where B = 10 to 40% Ga, remainder Al.

8. Conversion LED according to Claim 7, **characterized in that** the first phosphor is A3B5012, where A = 80 to 100% Lu, remainder Y, and having a Ce content of 1.5 to 2.5%, where B = 15 to 25% Ga, remainder Al.

## Revendications

1. DEL à conversion comprenant une puce qui émet un rayonnement primaire, ainsi qu'une couche en amont de ladite puce qui contient une substance luminescente et qui convertit au moins une partie du rayonnement primaire de la puce en rayonnement secondaire, dans laquelle il est utilisé une première substance luminescente émettant dans le jaune/vert du type grenat A3B5012:Ce et une deuxième substance luminescente émettant dans l'orange/rouge du type calsin MAlSiN3:Eu, **caractérisée en ce que** la longueur d'onde de pointe du rayonnement primaire est comprise entre 435 et 455 nm, la première substance luminescente étant un grenat avec le cation A = Lu ou Lu en combinaison avec Y, et B présentant simultanément des teneurs en Al et Ga, tandis que la deuxième substance luminescente est le MAlSiN3:Eu, contenant comme M du Ca dans une proportion d'au moins 80 %, en particulier d'au moins 90 %, de préférence d'au moins 95 %, M étant uniquement du Ca ou principalement du Ca et le reste de M pouvant être du Sr, Ba, Mg, Li ou Cu, chacun seul ou en combinaison, et une partie de Al jusqu'à 20 %, de préférence ne dépassant pas 5 %, pouvant être substituée par B, O, F, Cl, seuls ou en combinaison.

2. DEL à conversion selon la revendication 1, **caractérisée en ce que** la première substance luminescente contient 10 à 40 % en mole de Ga, en particulier 20 à 30 %, pour le composant B, le reste étant Al.

3. DEL à conversion selon la revendication 1, **caractérisée en ce que** la première substance luminescente contient 1,5 à 2,9 % en mole de Ce, en particulier 1,8 à 2,6 % en mole de Ce, comme dopant ajouté au composant B, le reste étant Al.

4. DEL à conversion selon la revendication 1, **caractérisée en ce que** la deuxième substance luminescente contient uniquement du Ca comme composant M.

5. DEL à conversion selon la revendication 1, **caractérisée en ce que** la deuxième substance luminescente contient 0,2 à 1,3 % en mole de Eu, en particulier 0,3 à 0,9 %, comme dopant ajouté au composant M.

6. DEL à conversion selon la revendication 1, **caractérisée en ce que** la deuxième substance luminescente est le CaAlSiN3:Eu, avec une proportion de Eu de 0,3 à 0,8 % dans M.

7. DEL à conversion selon la revendication 6, **caractérisée en ce que** la première substance luminescente est le A3B5012, avec A = 75 à 100 % de Lu, reste Y et une teneur en Ce de 1,5 à 2,5 %, avec B = 10 à 40 % de Ga, reste Al.

8. DEL à conversion selon la revendication 7, **caractérisée en ce que** la première substance luminescente est le A3B5012, avec A = 80 à 100 % de Lu, reste Y et une teneur en Ce de 1,5 à 2,5 %, avec B = 15 à 25 % de Ga, reste Al.
